# EUROPÄISCHE PATENTSCHRIFT

(11) **EP 4 348 277 B1**
(45) Veröffentlichungstag und Bekanntmachung des Hinweises auf die Patenterteilung: **09.07.2025**
(21) Anmeldenummer: 22731659.3
(22) Anmeldetag: 03.06.2022
(51) Int. Cl.: G01R 1/067, G01R 1/073

(54) **PRÜFKOPF FÜR EINEN FINGERTESTER UND VERFAHREN ZUM TESTEN VON LEITERPLATTEN**
TEST BODY FOR A FINGER TESTER, AND METHOD FOR TESTING PRINTED CIRCUIT BOARDS
TÊTE DE CONTRÔLE POUR TESTEUR À SONDE MOBILE ET PROCÉDÉ POUR TESTER DES CARTES DE CIRCUITS IMPRIMÉS

(30) Priorität: 04.06.2021 DE 102021114443
(43) Veröffentlichungstag der Anmeldung: 10.04.2024
(73) Patentinhaber: atg Luther & Maelzer GmbH, 97877 Wertheim (DE)
(72) Erfinder: WEINDEL, Christian, 75248 Ölbronn-Dürrn (DE); OTT, Bernd, 74653 Künzelsau (DE)
(74) Vertreter: HGF
(86) Internationale Anmeldenummer: PCT/EP2022/065184
(87) Internationale Veröffentlichungsnummer: WO 2022/254005

(56) Entgegenhaltungen:
- CN-A- 113 341 183
- DE-A1- 102013 102 564
- DE-T2- 69 712 849

## Beschreibung

Die vorliegende Erfindung betrifft einen Prüfkopf für einen Fingertester, sowie einen Fingertester mit mehreren solcher Prüfköpfe und ein Verfahren zum Testen von Leiterplatten mit einem solchen Fingertester.

Fingertester sind Testvorrichtungen, mit welchen Kontaktstellen von Leiterplatten aufeinanderfolgend mit jeweils einem Kontaktfinger bzw. Testfinger kontaktiert werden. Beim Testen von unbestückten Leiterplatten werden die Leiterbahnen einer zu testenden Leiterplatte vor allem auf Unterbrechungen der Leiterbahnen und auf Kurzschlüsse zwischen den Leiterbahnen getestet. Die Messungen erfolgen in der Regel als Widerstands- und/oder Kapazitätsmessungen.

Ein grundlegender Aufbau eines solchen Fingertesters geht aus der EP 0 468 153 B1 hervor. Hier ist ein Fingertester offenbart, der mehrere Kontaktfinger aufweist, welche an einem Schlitten um eine vertikale Achse drehbar gelagert sind und in ihrer Höhe verstellbar sind, wobei die Schlitten der einzelnen Kontaktfinger an horizontalen Traversen verschieblich gelagert sind. Die Traversen selbst sind in Horizontalrichtung quer zur Längsrichtung der jeweiligen Traverse verfahrbar.

Es sind auch derartige Fingertester bekannt, bei welchen mehrere Traversen ortsfest angeordnet sind.

Aus der EP 0 853 242 A1 geht ein Verfahren zur Prüfung von Leiterplatten mittels eines Fingertesters hervor.

In der EP 1 542 023 B1 ist ein Fingertester zum Testen von unbestückten Leiterplatten beschrieben, der am Prüfkopf einen luftgelagerten Linearmotor aufweist. Ein solcher luftgelagerter Linearmotor erlaubt eine sehr schnelle Vertikalbewegung des Prüfkopfes, wodurch die Prüfsonde mit einer Kontaktstelle einer zu prüfenden Leiterplatte schnell kontaktiert werden kann.

Aus der DE 10 2013 102 564 A1 geht eine Traverseneinheit für eine Prüfvorrichtung für Leiterplatten hervor, die sich dadurch auszeichnet, dass die Traverseneinheit ausgebildet ist, wenigstens zwei voneinander unabhängige Linearführungen zum Führen von jeweils wenigstens einer der Positioniereinheit aufzunehmen.

Aus der CN 113 341 183 A geht ein Prüfkopf hervor, der auf einer Rotationsscheibe angeordnet ist. Dieses Dokument ist erst nach dem Zeitrang der vorliegenden Patentanmeldung veröffentlicht worden.

Aus der DE 697 12 849 T2 bzw. der EP 836 098 B1 geht ein lineares Betätigungselement hervor, das eine hohe Steifigkeit aufweisen soll. Die Anmelderin der vorliegenden Patentanmeldung vertreibt unter den Produktbezeichnungen A7 und A8 derartige Fingertester, welche einen Prüfkopf mit einer vertikalen Führungsschiene mit einem Wälzlager aufweisen und somit nicht luftgelagert sind.

Die Anmelderin produziert und vertreibt weiterhin Fingertester unter den Produktbezeichnungen S2 und S3, welche am Prüfkopf für die Vertikalbewegung einen Linearmotor mit Luftlagerung aufweisen.

Die Prüfköpfe mit Luftlagerung sind wesentlich schneller als die ohne Luftlagerung, jedoch auch in der Herstellung erheblich aufwändiger und dem entsprechend teurer. Bei luftgelagerten Prüfköpfen sind die vom Luftlager getragenen Teile sehr leicht ausgebildet. Dies sind insbesondere die Arme der Kontaktfinger, welche die Prüfsonden tragen. Diese Arme sind sehr filigran. Hierdurch verursachen sie nur ein sehr geringes Trägheitsmoment. Sie sind aber in ihrer Länge begrenzt und empfindlich für Beschädigungen. Beim Austausch von Prüfsonden kann deshalb der Arm leicht beschädigt werden.

Zum Testen von Leiterplatten sind neben Fingertestern auch Paralleltester bekannt, welche jeweils einen Adapter aufweisen, um alle Kontaktstellen einer zu testenden Leiterplatte gleichzeitig zu kontaktieren. Ein solcher Paralleltester ist prinzipbedingt wesentlich schneller als ein Fingertester, jedoch muss für einen jeden Typ von Leiterplatte ein separater Adapter hergestellt werden, der wiederum sehr teuer ist.

Der Erfolg von Fingertestern am Markt wird vor allem durch die Testgeschwindigkeit, mit welcher die Vielzahl der Kontaktstellen einer zu testenden Leiterplatte vermessen werden können, bestimmt. Eine Leiterplatte weist in der Regel einige Tausend Kontaktstellen auf. Viele Leiterplatten werden nur in Kleinserie gefertigt oder sind Vorserien, die zum Hochfahren einer Massenproduktion benötigt werden, so dass sich hier oftmals die Herstellung eines Adapters für einen Paralleltester nicht lohnt. Sie sind jedoch aufgrund ihrer Komplexität und ihrer Vielzahl von Kontaktstellen sehr aufwändig zu testen.

Aufgabe der Erfindung ist es, einen Fingertester derart weiterzubilden, dass er einerseits einfach aufgebaut und kostengünstig herstellbar ist und andererseits einen hohen Durchsatz an zu testenden Leiterplatten ermöglicht.

Nach einem ersten Aspekt der vorliegenden Erfindung wird ein Prüfkopf für einen Fingertester zum Prüfen von Leiterplatten vorgesehen, umfassend
- einen Schlitten, der an einer Traverse des Fingertesters verfahrbar angeordnet werden kann,
- ein Haltemodul zum Halten eines Schwenkarms, der am vom Haltemodul entfernten Ende zur Aufnahme einer Prüfsonde ausgebildet ist,
- eine Hubeinrichtung, mit welcher das Haltemodul in Vertikalrichtung bezüglich des Schlittens beweglich ausgebildet ist, wobei die Hubeinrichtung eine vertikale Führungsschiene mit einem Wälzlager aufweist,
- eine Schwenkeinrichtung zum Drehen des Haltemoduls und damit des Schwenkarmes um eine vertikale Drehachse, wobei die Schwenkeinrichtung einen Motor zum Drehen der Schwenkeinrichtung aufweist.

Der Prüfkopf zeichnet sich dadurch aus, dass die Schwenkeinrichtung eine Welle oder Achse aufweist, wobei ein Drehkörper der Schwenkeinrichtung konzentrisch zur Welle oder Achse angeordnet ist, so dass der Drehkörper die Welle oder Achse umgibt, und der Drehkörper entweder auf der Achse mit zumindest einem Lager gelagert ist oder über die Welle am Schlitten mit zumindest einem Lager gelagert ist, und
der Motor als Direktmotor ausgebildet ist, wobei der Drehkörper den Rotor des Motors bildet.

Die Achse ist am Schlitten ortsfest, d.h. nicht drehend angeordnet, wohingegen sich die Welle bzgl. des Schlittens drehen kann.

Der Motor ist zum direkten Antrieb der Schwenkeinrichtung ohne Zwischenschaltung eines Getriebes ausgebildet. Da der Drehkörper die Achse oder Welle umgibt, hat er einen größeren Durchmesser als die Achse oder Welle. Der Drehkörper stellt einerseits den Rotor des Motors dar und ist andererseits integraler Bestandteil der Schwenkeinrichtung. Zudem kann aufgrund des relativ großen Durchmessers des Drehkörpers ein hohes Drehmoment ausgeübt werden, das eine entsprechend hohe Beschleunigung bei der Drehbewegung erlaubt.

Vorzugseise ist der Motor ein Torquemotor. Ein Torquemotor kann vereinfacht als ein auf hohe Drehmomente optimierter, großer Servomotor betrachtet werden. Torquemotoren werden üblicherweise als bürstenlose Gleichstrommotoren gebaut. Teilweise werden aber auch geschaltete Reluktanzmotoren als Torquemotoren verwendet. Vorzugsweise ist der Torquemotor ein hochpoliger Servomotor mit z.B. zumindest 20 Pole.

Der Erfindung liegen folgende Erkenntnisse zugrunde:
1. Beim Messen von mehreren Kontaktstellen einer zu testenden Leiterplatte wird die meiste Zeit zum Bewegen eines Testfingers von einer Kontaktstelle der Leiterplatte zu einer anderen Kontaktstelle der Leiterplatte und nicht zum Durchführen der einzelnen Messungen benötigt.
2. Eine luftgelagerte Linearführung, wie sie oben erläutert ist, erlaubt zwar eine sehr schnelle Vertikalbewegung des Prüfkopfes und verkürzt dadurch die Bewegungszeit, hat jedoch den Nachteil, dass aufgrund der Luftlagerung die mittels der Luftlagerung gelagerte bewegte Masse des Prüfkopfes begrenzt ist und hierdurch nur Testfinger mit relativ kurzer Armlänge von maximal bis zu etwa 150 mm möglich sind. Eine Lagerung mittels eines Wälzlagers, wie zum Beispiel ein Kugellager, Kreuzrollenlager oder dergleichen, kann zuverlässig auch höhere Massen und Momente übertragen und erlaubt längere Armlängen der Testfinger. Eine größere Armlänge hat mehrere Vorteile. Zum einen bedeutet eine größere Armlänge bei gleicher Drehgeschwindigkeit eine größere Bewegungsgeschwindigkeit der am Schwenkarm befestigten Prüfsonde. Zum anderen erlauben längere Schwenkarme auch größere Testbereiche. Die Anmelderin verwendet die Schwenkarme ausschließlich in einem Winkelbereich zwischen 0° und maximal etwa 45°, wobei 0° bedeutet, dass der Schwenkarm parallel zur Traverse angeordnet ist, an welcher der Schlitten des Prüfkopfes gelagert ist, und ein Winkel von 45° bedeutet, dass der Schwenkarm mit der Traverse einen Winkel von 45° einschließt. In diesem Winkelbereich wird eine sehr schnelle Bewegung der Prüfsonde weg von der Traverse bzw. in Richtung zur Traverse bewirkt. Bei größeren Winkeln nimmt die Bewegungsgeschwindigkeit der Prüfsonde in Querrichtung zur Traverse ab. Je länger der Schwenkarm ist, desto größer ist die Breite des Bereiches, der mit einem Prüfkopf entlang der entsprechenden Traverse abgedeckt werden kann.
3. Am Ende einer Schwenkbewegung schwingen die Schwenkarme etwas nach. Die eingangs erläuterten Prüfvorrichtungen weisen als Drehwelle Stahlwellen mit einem Durchmesser von 8 mm und einem Abstand zwischen einem Angriffspunkt des Motors (= Antrieb) und der Befestigungsstelle des Schwenkarms (= Abtrieb) auf der Welle von ca. 20 mm auf. Diese Wellen bestehen aus einem Vollkörper. Diese Wellen schwingen beim Abbremsen etwas aufgrund des axialen Versatzes zwischen dem Antrieb und dem Abtrieb. Die Welle bildet somit einen Körper, der einer Torsionsschwingung unterliegt.

Bei der Erfindung werden diese Torsionsschwingungen im Wesentlichen vermieden, da ein im Vergleich zur Welle wesentlich größerer Drehkörper direkt angetrieben wird, der aufgrund seiner Größe und Steifigkeit selbst keiner Torsion unterliegt und direkt an die Schwenkeinrichtung gekoppelt ist bzw. einen integralen Bestandteil der Schwenkeinrichtung bildet, so dass eine Übertragung eines Drehmomentes über eine dünne Welle vermieden wird. Die Achse oder die Welle dienen lediglich zur Lagerung der Schwenkeinrichtung aber nicht zum Übertragen der vom Motor ausgeübten Antriebskräfte auf die zu drehenden Massen der Schwenkeinrichtung, insbesondere die Hubeinrichtung und den Schwenkarm. Hierdurch wird die Torsion der herkömmlichen Welle vermieden. Dies wird durch die Trennung der Lagerung, welche an der Welle oder Achse stattfindet und des Antriebs auf den Drehkörper erzielt.

Vorzugsweise wird eine Achsen oder eine Welle mit einem minimalen Außendurchmesser von zumindest 10 mm an dem Bereich ausgebildet ist, an dem das Lager an der Welle oder Achse angeordnet ist. Die Schwenkeinrichtung ist entweder auf der Achse oder mittels der Welle gelagert. Die Achse bzw. Welle kann im Bereich des Lagers auch einen Außendurchmesser von zumindest 20 mm, insbesondere zumindest 25 mm bzw. zumindest 30 mm oder sogar zumindest 35 mm aufweisen. Je größer der Durchmesser der Welle bzw. Achse ist, desto stabiler ist die Lagerung der Schwenkeinrichtung.

Vorzugsweise ist der Drehkörper mit einem maximalen Außendurchmesser von zumindest 50 mm ausgebildet ist. Der Drehkörper kann auch einen maximalen Außendurchmesser von zumindest 60 mm, insbesondere zumindest 70 mm und vorzugsweise zumindest 80 mm aufweisen. Je größer der Außendurchmesser des Drehkörpers/Rotors ist, desto größer ist auch das mit ihm erzeugte Drehmoment.

Ist die Prüfsonde mit ihrer Prüfspitze mit einer Schwenkbewegung in einen Zielbereich mit einer Breite von 5 µm einzustellen, dann verursachen die Torsionsschwingungen eine Verzögerung, bis sie abgeklungen sind, von 40 ms mit einer herkömmlichen Welle mit einem Durchmesser von 8 mm und mit einem Abstand zwischen dem Antrieb und dem Abtrieb auf der Welle von 20 mm. Bei einem Zielfenster von 25 µm werden immer noch 5 ms zum Ausschwingen benötigt.

Es hat sich gezeigt, dass die Verwendung einer Achse bzw. Welle mit einem Außendurchmesser von zumindest 15 mm und einer erfindungsgemäßen Ausgestaltung des Prüfkopfes die Zeit zum Nachschwingen bei einem Zielfenster von 5 µm auf 7 ms und bei einem Zielfenster von 25 µm auf 1 ms reduziert. Weist die Achse bzw. Welle einen Außendurchmesser von 55 mm auf, dann reduziert sich die Zeit für das Ausschwingen bei einem Zielfenster von 5 µm auf weniger als 0,5 ms. Bei diesem Einschwingvorgang gibt es keine Torsionsschwingung einer Welle sondern ein komplexes Schwingungsverhalten des Schwenkarms und Kippschwingungen der Welle oder Achse, die umso geringer sind, je größer deren Durchmesser ist. Bei einem Außendurchmesser der Achse oder Welle von 55 mm besteht somit praktisch kein Zeitbedarf mehr für das Ausschwingen einer Schwenkbewegung aufgrund der hohen Festigkeit des Lagers.

Die Schwenkeinrichtung wird nicht über eine von einem Motor angetriebene Welle angetrieben, sondern ist entweder auf einer ortsfesten bzw. nicht drehenden Achse drehbar gelagert oder ist mittels einer Welle gelagert, welche vorzugsweise einen minimalen Außendurchmesser von 10 mm aufweist. Solche Außendurchmesser erfordern dementsprechend große und stabile Lager. Zudem greift der Torquemotor direkt an der Schwenkeinrichtung unabhängig von der Achse oder Welle an. Die Kräfte werden an dem Drehkörper eingeleitet, der einen größeren Durchmesser als die Welle oder Achse aufweist. Hierdurch kann ein entlang Axialrichtung einer dünnen Welle versetzter An- und Abtrieb vermieden werden, wie er im Stand der Technik üblich ist. Da bei herkömmlichen Schwenkeinrichtungen der An- und Abtrieb an der dünnen Welle in Axialrichtung voneinander beabstandet ist, führt dies zu Torsionsschwingungen der Welle, welche, wie die Erfinder herausgefunden haben, das Einschwingen bei kleinen Kontaktstellen einer zu testenden Leiterplatte erheblich verzögern.

Bei Fingertestern der Anmelderin werden die Leiterplatten in einem Prüfbereich horizontal liegend angeordnet. Deshalb wird in der vorliegenden Beschreibung mit "vertikal" eine Richtung bezeichnet, die senkrecht auf der Oberfläche einer zu testenden, im Fingertester befindlichen Leiterplatte bezeichnet. Grundsätzlich ist es auch möglich, dass in der Prüfvorrichtung die zu testenden Leiterplatten nicht horizontal, sondern z.B. schräg oder vertikal angeordnet sein können. Dann sind die einzelnen Elemente der Prüfvorrichtung dementsprechend auszurichten.

Die Armlänge des Schwenkarms beträgt vorzugsweise zumindest 150 mm. Die Armlänge wird von der vertikalen Drehachse bis zum freien Ende des Schwenkarmes gemessen, an den die Prüfsonde befestigbar ist. Als effektive Armlänge wird die Armlänge von der vertikalen Drehachse bis zu einer Spitze der Prüfsonde, mit welcher eine Kontaktstelle einer zu testenden Leiterplatte zu kontaktieren ist, bezeichnet. Die effektive Armlänge beträgt vorzugsweise zumindest 160 mm, insbesondere zumindest 170 mm bzw. zumindest 180 mm.

Das Lager ist vorzugsweise zumindest ein Schrägkugellager.

Vorzugsweise ist die Welle am Schlitten oder ist der Drehkörper an der Achse mit einem Satz von zumindest zwei Schrägkugellagern gelagert, wodurch die sich drehenden Teile sehr exakt positionierbar und sehr exakt bezüglich der Drehachse angeordnet und gehalten werden können.

Das bzw. die Schrägkugellager weisen vorzugsweise Keramikkugeln auf.

Vorzugsweise sind der Motor und der Drehkörper etwa in derselben Ebene wie das zumindest eine Wälzlager angeordnet. Hierdurch gibt es keine oder nur sehr geringe Kippmomente, welche durch einen axialen Versatz des Antriebs und des Lagers verursacht werden können. Zudem ist eine Anordnung von Motor, Drehkörper und Lager, insbesondere Wälzlager, in etwa einer Ebene sehr platzsparend und kompakt.

In etwa einer Ebene bedeutet, dass es eine Ebene gibt, die sich gleichzeitig durch den Bereich erstreckt, in dem das bzw. die Wälzlager angeordnet sind, und die sich gleichzeitig durch den Drehkörper und den Motor hindurcherstreckt. Hierdurch ist der Motor konzentrisch in einer Ebene mit der Lagerung angeordnet, so dass durch den Betrieb des Motors keine oder nur sehr geringe Kippmomente auf den Drehkörper bzw. die Welle ausgeübt werden.

Weist die Schwenkeinrichtung eine Welle auf, dann beträgt die maximale Länge der Welle vorzugsweise 40 mm und insbesondere lediglich 30 mm. Je kürzer die Welle ist, desto steifer ist sie.

Der Schwenkarm ist vorzugsweise rohrförmig aus einem Faserverbundmaterial ausgebildet. Hierdurch besitzt der Schwenkarm eine hohe Festigkeit bei einem geringen Gewicht.

Insbesondere besteht der Schwenkarm aus einem monolithischen Körper. Die Fasern des Faserverbundmaterials sind vorzugsweise Karbonfasern. Ein solcher monolithischer Körper besitzt eine hohe Steifigkeit.

Ein solcher Schwenkarm kann einerseits relativ lang und leicht ausgebildet sein und andererseits aufgrund seiner hohen Festigkeit zur Vermeidung von Schwingungen der Prüfsonde beim Anfahren an eine zu kontaktierende Kontaktstelle einer zu prüfenden Leiterplatte beitragen. Dies gilt insbesondere für dir monolithische rohrförmige Ausbildung des Schwenkarmes aus einem Faserverbundwerkstoff. Dieser Schwenkarm ist daher sehr vorteilhaft in Kombination mit dem oben erläuterten Direktantrieb und der Lagerung der Hubeinrichtung mit einem Wälzlager. Mit dem Direktantrieb werden die aus dem Stand der Technik bekannten Torsionsschwingungen an einer Antriebswelle vermieden und das Wälzlager an der Hubeinrichtung erlaubt die Verwendung eines langen Schwenkarms.

Der Schwenkarm kann in Richtung zum freien Ende verjüngt ausgebildet sein. Hierdurch wird das Gewicht in Richtung zum freien Ende des Schwenkarmes verringert, wodurch das Trägheitsmoment des Schwenkarmes gering gehalten wird. Zudem trägt die Verjüngung auch zur Versteifung des Schwenkarmes bei.

Der Schwenkarm kann in der Seitenansicht derart gekrümmt geformt sein, dass das freie Ende des Schwenkarms gegenüber dem an der Schwenkeinrichtung befestigten Ende ein Stück versetzt angeordnet ist. Der Schwenkarm kann somit mit dem freien Ende ein Stück weg vom Schlitten versetzt angeordnet sein. Der Schwenkarm ist somit ein Stück in Richtung zu einem Prüfbereich gebogen, in dem ein Prüfling zum Prüfen angeordnet wird. Diese Krümmung des Schwenkarmes erhöht zum einen die Steifigkeit des Schwenkarmes und schafft Platz für die Anordnung einer Kamera oberhalb des Schwenkarmes, welche an der Schwenkeinrichtung befestigbar ist, so dass mit der Kamera die Prüfsonde und insbesondere eine Kontaktspitze der Prüfsonde detektierbar ist, um festzustellen, ob mit der Prüfsonde ein Testpunkt einer zu testenden Leiterplatte korrekt kontaktiert wird.

Der Prüfkopf kann somit mit einer Kamera zum Überwachen der Positionierung der Prüfspitze einer Prüfsonde versehen sein.

Der Drehkörper bzw. Rotor kann mehrere Permanentmagnete am äußeren Umfang aufweisen, welche mit Magnetfeldspulen eines Stators des Motors zusammenwirken. Da die Magnetfeldspulen am Stator angeordnet sind, müssen keine Ströme auf den Rotor übertragen werden, um den Motor anzutreiben. Dies vereinfacht die Ausgestaltung der Vorrichtung.

Der Stator und der Rotor des Motors sind vorzugsweise so ausgebildet, dass sie sich um einen vollständigen Kreis erstrecken. Da der Motor an sich nur verwendet wird, um sich in einem Drehbereich von ± 45° zu drehen, könnte der Stator und/oder der Rotor auch lediglich in Form eines Kreissegmentes ausgebildet sein. Erstrecken sich der Stator und der Rotor jedoch um einen vollständigen Kreis, dann kann bei kompakter Bauweise des Motors ein wesentlich größeres Drehmoment erzielt werden, als wenn der Stator oder Rotor sich nur über einen Kreissegmentabschnitt erstrecken würde. Aufgrund dieses großen Drehmomentes kann die Schwenkeinrichtung schnell geschwenkt werden. Dies ist insbesondere in Kombination mit einem langen Schwenkarm von Vorteil, da hierdurch die Prüfsonde sehr schnell zwischen den einzelnen zu kontaktierenden Kontaktstellen einer zu testenden Leiterplatte bewegt werden kann.

Die Hubeinrichtung ist vorzugsweise an der Schwenkeinrichtung angeordnet und weist einen Linearmotor zum Bewegen des Haltemoduls auf.

Am Schlitten kann ein Läufer eines Linearmotors ausgebildet sein, um den Schlitten zu bewegen.

Vorzugsweise ist die Hubeinrichtung versetzt von der vertikalen Drehachse der Schwenkeinrichtung angeordnet, so dass ein Kabel, das im Wesentlichen zur Übertragung von Messsignalen und zur Motorsteuerung dient, etwa entlang der vertikalen Rotationsachse im Bereich zwischen dem Haltemodul und dem Schlitten geführt ist. Dies erhöht zwar etwas das Trägheitsmoment des Prüfkopfes, bewirkt jedoch eine erhebliche Verlängerung der Lebensdauer dieses Kabels, da es bei einer anderen Ausgestaltung des Prüfkopfes beim Drehen des Drehkopfes wesentlich stärker bewegt werden würde.

Nach einem weiteren Aspekt der Erfindung wird ein Fingertester zum Testen von Leiterplatten, insbesondere zum Testen von unbestückten Leiterplatten, vorgesehen, der zumindest zwei Traversen aufweist, an welchen jeweils zumindest ein Prüfkopf angeordnet ist, wie er oben erläutert ist.

Beim Testen von unbestückten Leiterplatten werden die Leiterbahnen auf Unterbrechungen und Kurzschlüsse zwischen benachbarten Leiterplatten getestet. Im Vergleich zu bestückten Leiterplatten sind wesentlich mehr Testpunkte der Leiterplatte zu kontaktieren und die Prüfköpfe wesentlich öfter zu bewegen. Daher ist die Verfahrzeit zum Verfahren einer Prüfspitze von einem Testpunkt einer Leiterplatte zu einem weiteren Testpunkt einer zu testenden Leiterplatte beim Testen von unbestückten Leiterplatten wesentlich bedeutsamer als beim Testen von bestückten Leiterplatten. Die Prüfköpfe dieses Fingertesters erlauben eine sehr schnelle Bewegung der Prüfsonden mit ihren Prüfnadeln von einem Testpunkt zu einem weiteren Testpunkt.

Vorzugsweise ist eine jede Traverse aus einem Steinblock ausgebildet. In dem Steinblock kann eine Nut eingebracht sein, in dem sich ein Stator eines Linearmotors befindet, so dass der am Prüfkopf vorgesehene Läufer des Linearmotors gegenüber dem Stator bewegt wird. Weiterhin können am Steinblock Führungselemente bzw. Führungsschienen vorgesehen sein, in welchen der Schlitten entlang der Traverse geführt wird. Der Steinblock ist vorzugsweise ein Granitblock.

Nach einem weiteren Aspekt der vorliegenden Erfindung wird ein Verfahren zum Testen von Leiterplatten, insbesondere zum Testen von unbestückten Leiterplatten, vorgesehen, wobei ein Fingertester verwendet wird, wie er oben erläutert ist. Bei diesem Verfahren wird nach einer Schwenkbewegung eines der Schwenkarme nicht mehr als 5 ms zum Einschwingen des Schwenkarmes gewartet, bis eine zu testende Kontaktstelle kontaktiert wird.

Nachfolgend wird die Erfindung beispielhaft näher anhand der Zeichnungen erläutert, die zeigen in:
- Figur 1: einen Fingertester mit vier Traversen und acht Prüfköpfen in einer perspektivischen Ansicht,
- Figur 2: das aus Granit ausgebildete Gestell des Fingertesters ohne Prüfköpfe in einer Seitenansicht,
- Figur 3a: einen Prüfkopf in einer Ansicht vom Prüfbereich in Richtung zum Prüfkopf,
- Figur 3b: den Prüfkopf aus Figur 3a in einer seitlichen Schnittansicht,
- Figur 3c: den Prüfkopf aus Figur 3a in einer perspektivischen Schnittansicht,
- Figur 4: eine Schnittansicht durch einen Prüfkopf eines weiteren Ausführungsbeispiels.

Ein Ausführungsbeispiel eines erfindungsgemäßen Fingertesters 1 weist ein Gerüst 2 auf, an dem insgesamt vier Traversen 3 ausgebildet sind, in welchen jeweils zwei Prüfköpfe 4 verfahrbar angeordnet sind.

Das Gerüst 2 besteht aus Granitsteinen und umfasst eine in der Draufsicht Doppel-T-förmige Bodenplatte 5 und eine in der Draufsicht Doppel-T-förmige Deckenplatte 6. Die Bodenplatte 5 und die Deckenplatte 6 weisen jeweils einen Längsträger 7 auf, an dessen Enden jeweils an beiden Seiten ein Vorsprung 8 vorsteht. Die Deckenplatte 6 und die Bodenplatten 5 sind in der Draufsicht fluchtend zueinander angeordnet, wobei sich zwischen den jeweiligen Vorsprüngen 8 jeweils vertikale Säulen 9 befinden.

An den zueinander weisenden Oberflächen der Längsträger 7 sind jeweils zwei in Längsrichtung verlaufende Nuten 10 ausgebildet, welche jeweils eine der Traversen 3 bilden. In den Nuten 10 ist jeweils ein Stator 11 eines Linearmotors angeordnet, der sich über einen Großteil der Länge der Nut 10 erstreckt.

Benachbart neben den Nuten 10 sind an den zueinander weisenden Oberflächen der Längsträger 7 Führungsschienen 12 angeordnet, an welchen die Prüfköpfe 4 mit entsprechenden Gegenführungselementen 18 gleiten können.

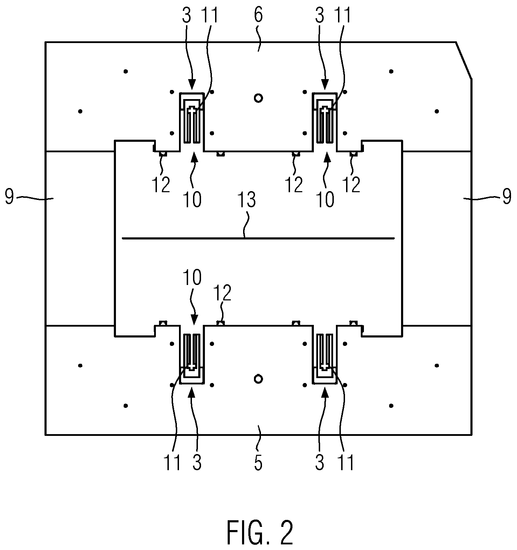

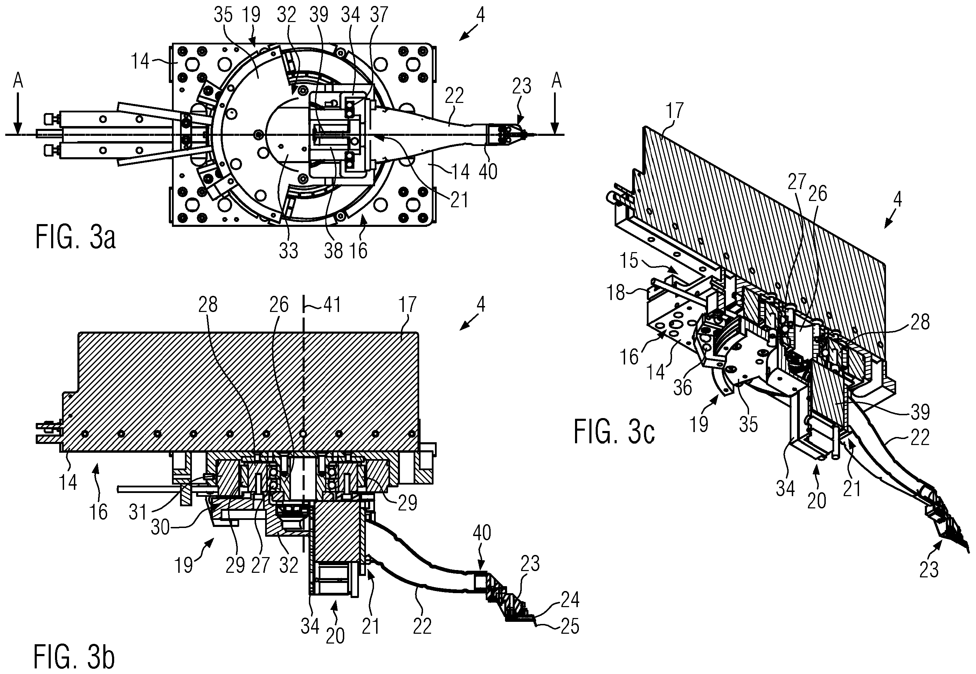

Mittig und parallel zu den Längsträgern 7 ist ein Prüfbereich 13 ausgebildet, in welchen eine zu testende Leiterplatte aufgenommen werden kann. In Figur 2 und 3a ist der Prüfbereich 13 schematisch lediglich durch eine Platte dargestellt, die sich dort befindet, wo eine zu testende Leiterplatte anzuordnen ist. Der Prüfbereich 13 weist entsprechende Halteelemente zum Halten der Leiterplatte auf, die zur Vereinfachung der Zeichnungen hier weggelassen sind.

Die Prüfköpfe 4 weisen jeweils einen in der Draufsicht etwa plattenförmigen Grundkörper 14 auf, der eine zur Traverse weisende Traversenseite 15 und eine hiervon abgewandte Prüfkopfseite 16 aufweist.

An der Traversenseite 15 ist ein plattenförmiger Läufer 17 eines Linearmotors angebracht, der senkrecht auf der Traversenseite 15 angeordnet ist. Benachbart zu dem Läufer 17 sind Führungselemente 18 zum Gleiten in den Führungsschienen 12 vorgesehen.

An der Prüfkopfseite 16 ist eine Schwenkeinrichtung 19 vorgesehen, an welcher eine Hubeinrichtung 20 ausgebildet ist, welche ein Haltemodul 21 in Vertikalrichtung bewegen kann, an dem ein Schwenkarm 22 befestigt ist. Der Schwenkarm ist an dem vom Haltemodul 21 entfernten freien Ende zur Aufnahme einer Prüfsonde 23 ausgebildet. Die Prüfsonde 23 weist eine Prüfnadel 24 mit einer Prüfspitze 25 zum Kontaktieren von Kontaktstellen einer zu testenden Leiterplatte auf.

Die Schwenkeinrichtung 19 ist zum Drehen der Einheit umfassend die Hubeinrichtung 20, das Haltemodul 21, den Schwenkarm 22 und die Prüfsonde 23 um eine Drehachse 41, welche senkrecht auf dem Prüfbereich 13 steht.

Die Schwenkeinrichtung 19 weist eine ortsfest am Grundkörper 14 befestigte vertikale Achse 26 auf. Im vorliegenden Ausführungsbeispiel ist die vertikale Achse 26 aus einem rohrförmigen Körper ausgebildet. Am Außenumfang der vertikalen Achse 26 sind zwei Wälzlager 27 angeordnet. Die vertikale Achse 26 hat einen großen Außendurchmesser, der im vorliegenden Ausführungsbeispiel im Bereich, an dem die Lager 27 an der Achse anliegen 35 mm beträgt. Die Wälzlager 27 sind Schrägkugellager, welche miteinander verpresst und gegensinnig ausgerichtet sind. Hierdurch kann eine sehr kippstabile Lagerung erzielt werden. Am Außenumfang der Wälzlager 27 sitzt ein Drehkörper 28. Der Drehkörper 28 ist ein etwa zylinderförmiger rotationssymmetrischer Körper, der mittels der Wälzlager 27 um die vertikale Achse 26 drehbar gelagert ist.

Der Drehkörper 28 weist an seinem Außenumfang im regelmäßigen Abstand angeordnete Permanentmagnete 29 auf und bildet einen Rotor eines Motors 30. Der Motor 30 ist als Torquemotor ausgebildet. Ein Stator des Motors 30 ist am Grundkörper 14 ortsfest befestigt und umgibt den Drehkörper 28. Der Stator 31 weist eine Vielzahl Magnetspulen (nicht dargestellt) auf, welche derart angesteuert werden, dass auf den Drehkörper 28, der den Rotor des Motors 30 bildet, ein Drehmoment ausgeübt wird.

Im vorliegenden Ausführungsbeispiel weist der Motor 30 achtundzwanzig Pole auf, d.h., dass am Drehkörper 28 dementsprechend viel Permanentmagnete angeordnet sind. Der Motor weist vorzugsweise zumindest zwanzig Pole auf.

Am Drehkörper 28 ist ein Schwenkgrundkörper 32 befestigt, der einen zentralen Abschnitt 33 einen Hubschienenkörper 34 und einen den Hubschienenkörper 34 am zentralen Abschnitt 33 diametral gegenüberliegenden Ausgleichsabschnitt 35 aufweist. Der Ausgleichsabschnitt 35 weist in der Draufsicht die Form eines Kreissegmentes auf und dient als Gegengewicht zum Hubschienenkörper 34 . Hierdurch befindet sich der Schwerpunkt der Schwenkeinrichtung 19 in der Nähe der Rotationsachse 41.Am äußeren Umfang des Ausgleichsabschnitts 35 ist eine Strichskala ausgebildet, welche mittels eines optischen Sensors 36 abgetastet wird. Hiermit wird die Drehposition der Schwenkeinrichtung 19 detektiert.

Der Hubschienenkörper (34) hat eine vertikale Führungsschiene.

Das Haltemodul 21 ist mittels Wälzlager 37 am Hubschienenkörper 34 gelagert, sodass das Haltemodul 21 in vertikaler Richtung am Hubschienenkörper 34 beweglich ausgebildet ist. Der Hubschienenkörper 34 weist einen Stator 38 eines Linearmotors und das Haltemodul 21 einen entsprechenden Läufer 39 des Linearmotors auf. Die Wälzlager 37 sind Bestandteil einer Kreuzrollenführung, welche zwischen dem Haltemodul 21 und dem Hubschienenkörper 34 angeordnet ist.

Das Haltemodul 21 bildet zusammen mit dem Läufer 39 in der Draufsicht einen T-förmigen Körper, wobei sich der Läufer 39 in einer durch den Stator 38 ausgebildeten Nut befindet, sodass der Linearmotor mit einem nach oben oder nach unten gerichteten Kraftmoment beaufschlagt werden kann, um das Haltemodul 21 in Vertikalrichtung zu bewegen. Hierdurch wird das Haltemodul 21 zusammen mit dem Schwenkarm 22 nach unten bzw. oben bewegt.

Der Schwenkarm 22 ist ein einteiliger, monolitischer Körper aus einem faserverstärkten Verbundmaterial. Insbesondere besteht der Schwenkarm aus einem Faserverbundmaterial mit Karbonfasern. Der Schwenkarm ist rohrförmig ausgebildet mit einem etwas kreisförmigen oder ellipsenförmigen Querschnitt. Der Schwenkarm ist mit einem Ende am Haltemodul 21 befestigt und weist ein freies, von Haltemodul 21 entferntes Ende 40 auf. Am freien Ende 40 des Schwenkarms 22 ist die Prüfsonde 23 angeordnet. Eine solche Prüfsonde ist z. B. aus der WO 03/048787 bekannt.

Die elektrischen Leitungen, mit welchen die Motoren angesteuert werden, bzw. mit welchen die Messsignale von der Prüfsonde 23 zu einer Auswertevorrichtung (nicht dargestellt) übertragen werden, sind in den Zeichnungen zur einfacheren Darstellung nicht gezeigt. Die elektrischen Leitungen zur Übertragung der Messsignale können innerhalb des hohlen Schwenkarms und durch die hohle, vertikale Achse 26 hindurchgeführt werden. Die Hubeinrichtung 20 ist etwas versetzt zu einer Drehachse 41 angeordnet, welche mittig durch die hohle, vertikale Achse 26 verläuft. Die hohle vertikale Achse 26 ist ein Körper, wohingegen die Drehachse 41 eine geometrische Linie ist. Die Achse 26, die Wälzlager 27, der Drehkörper 28 und der Stator 31 des Motors 30 sind alle konzentrisch zur Drehachse 41 angeordnet und befinden sich alle in der gleichen Ebene. Diese Anordnung ist einerseits raumsparend und andererseits frei von Kippmomenten, welche vorhanden wären, wenn der Antrieb bezüglich der Drehachse 41 versetzt von den Lagern 27 angeordnet wäre.

Diese spezielle Art des Antriebs bzw. der Lagerung in Verbindung mit der mittels Wälzlager 37 gelagerten Hubeinrichtung 20 erlaubt die Verwendung eines großen Schwenkarmes 22, sodass mit einem Prüfkopf 4 ein breiter Abtastbereich entlang einer Traverse abgetastet werden kann und zudem die Prüfsonde 23 sehr schnell von der Traverse weg bzw. in Richtung zur Traverse bewegt werden kann. Der Prüfkopf 4 ist im Vergleich zu Prüfköpfen mit Luftlagerung wesentlich einfacher und kostengünstiger ausgebildet. Die spezielle Ausbildung der Schwenkeinrichtung erlaubt ein schnelles Drehen der Schwenkeinrichtung, wobei kein oder nur ein geringes Einschwingen beim Erreichen einer zu kontaktierenden Kontaktstelle notwendig ist. Somit kann auf wesentlich einfachere Art und Weise ein hoher Durchsatz beim Testen von bestimmten Leiterplatten erzielt werden.

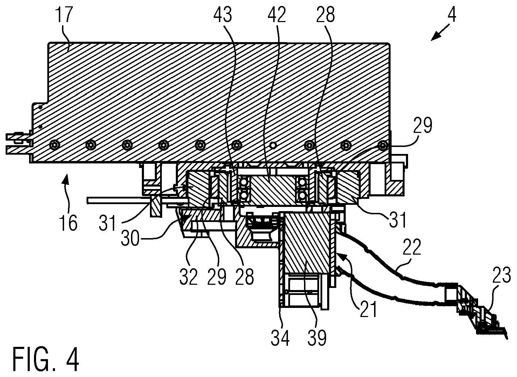

Nachfolgend wird ein zweites Ausführungsbeispiel der Erfindung erläutert (Figur 4). Das zweite Ausführungsbeispiel entspricht im Wesentlichen dem ersten Ausführungsbeispiel, wobei gleiche Teile mit dem gleichen Bezugszeichen versehen sind und nicht nochmals erläutert werden. Sofern nachfolgend nichts anderes angegeben ist, gelten die Ausführungen zum obigen ersten Ausführungsbeispiel gleichermaßen für das vorliegende zweite Ausführungsbeispiel.

Das zweite Ausführungsbeispiel unterscheidet sich vom ersten Ausführungsbeispiel dadurch, dass anstelle der ortsfesten vertikalen Achse 26 eine sich drehende Welle 42 vorgesehen ist, welche mittels der Wälzlager 27 drehbar an einer Buchse 43 gelagert ist. Die Buchse 43 umgibt konzentrisch die Welle 42 und die Wälzlager 27 und ist ortsfest am Grundkörper 14 des Prüfkopfs 4 befestigt. Die Welle 42 erstreckt sich in der Radialrichtung mit einer dünnen, scheibenförmigen Wandung über die Buchse 43 hinweg und ist mit dem Drehkörper 28 verbunden. Der Drehkörper 28 ist somit über die Welle 42 drehbar am Grundkörper bzw. Schlitten 14 des Prüfkopfes 4 gelagert.

Die Welle 42 kann als Vollkörper oder auch als Hohlwelle ausgebildet sein. Der Außendurchmesser der Welle 42 in dem Bereich, an dem die Welle 42 an der Innenseite der Wälzlager 27 anliegt, beträgt wiederum 35 mm.

Mit beiden Typen von Prüfköpfen 4 kann eine schnelle Schwenkbewegung ausgeführt werden, ohne dass ein langes Einschwenkverhalten auftritt. In Kombination mit dem aus Stein ausgebildeten Gerüst 2, das integral die Traversen 3 enthält, wird ein Fingertester geschaffen, mit dem Leiterplatten mit kleinsten Kontaktstellen zuverlässig und schnell kontaktiert werden können. Das Gewicht des Gerüsts 2 und dessen Steifheit verhindern, dass es aufgrund der Bewegung der Prüfköpfe 4 zu Schwingungen oder anderen unkontrollierten Bewegungen kommt, welche die Positioniergenauigkeit der Prüfsonden beeinträchtigen könnten.

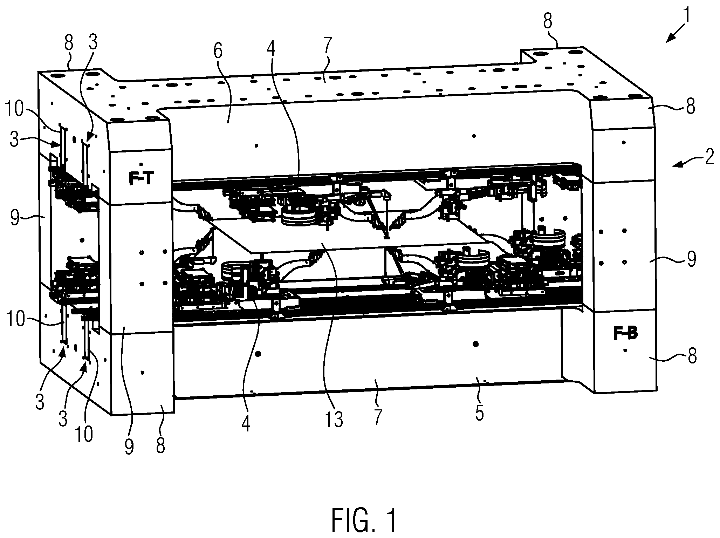

Vorzugsweise ist jeder zweite Prüfkopf mit einer Kamera 44 versehen (Figur 1), um die Position der Prüfnadel 24 bzw. der Prüfspitze 25 bezüglich entsprechender Kontaktstellen einer zu testenden Leiterplatte überwachen zu können.

### Bezugszeichenliste

| | | | |
|---|---|---|---|
| 1 | Fingertester | 23 | Prüfsonde |
| 2 | Gerüst | 24 | Prüfnadel |
| 3 | Traverse | 25 | Prüfspitze |
| 4 | Prüfkopf | 26 | vertikale Achse |
| 5 | Bodenplatte | 27 | Wälzlager |
| 6 | Deckenplatte | 28 | Drehkörper |
| 7 | Längsträger | 29 | Permanentmagnet |
| 8 | Vorsprung | 30 | Torquemotor |
| 9 | Säule | 31 | Stator |
| 10 | Nut | 32 | Schwenkgrundkörper |
| 11 | Stator | 33 | zentraler Abschnitt |
| 12 | Führungsschiene | 34 | Hubschienenkörper |
| 13 | Prüfbereich | 35 | Ausgleichsabschnitt |
| 14 | Grundkörper | 36 | optischer Sensor |
| 15 | Traversenseite | 37 | Wälzlager |
| 16 | Prüfkopfseite | 38 | Stator vom Linearmotor |
| 17 | Läufer | 39 | Läufer vom Linearmotor |
| 18 | Führungselement | 40 | freies Ende |
| 19 | Schwenkeinrichtung | 41 | Drehachse |
| 20 | Hubeinrichtung | 42 | Welle |
| 21 | Haltemodul | 43 | Buchse |
| 22 | Schwenkarm | 44 | Kamera |

## Patentansprüche

1. Prüfkopf (4) für einen Fingertester (1) zum Prüfen von Leiterplatten, umfassend
- einen Schlitten (14), der an einer Traverse (3) des Fingertesters verfahrbar angeordnet werden kann,
- ein Haltemodul (21) zum Halten eines Schwenkarms (22), der am vom Haltemodul (21) entfernten freien Ende (40) zur Aufnahme einer Prüfsonde (23) ausgebildet ist,
- einer Hubeinrichtung (20), mit welcher das Haltemodul (21) in Vertikalrichtung bzgl. des Schlittens beweglich ausgebildet ist, wobei die Hubeinrichtung (20) eine vertikale Führungsschiene mit einem Wälzlager (37) aufweist, und
- eine Schwenkeinrichtung (19) zum Drehen des Haltemoduls (21) und damit des Schwenkarmes um eine vertikale Drehachse (41), wobei die Schwenkeinrichtung (19) einen Motor (30) zum Drehen der Schwenkeinrichtung (19) aufweist,
**dadurch gekennzeichnet,**
**dass** die Schwenkeinrichtung (19) eine Welle (42) oder Achse (26) aufweist, wobei ein Drehkörper (28) der Schwenkeinrichtung (19) konzentrisch zur Welle (42) oder Achse (26) angeordnet ist, so dass der Drehkörper (28) die Welle (42) oder Achse (26) umgibt, und der Drehkörper (28) entweder auf der Achse (26) mit zumindest einem Lager (27) gelagert ist oder über die Welle (42) am Schlitten (14) mit zumindest einem Lager (27) gelagert ist, und
der Motor (30) als Direktantrieb ausgebildet ist, wobei der Drehkörper (28) den Rotor des Motors (30) bildet.

2. Prüfkopf (4) nach Anspruch 1,
**dadurch gekennzeichnet,**
**dass** die Länge des Schwenkarms zumindest 150 mm beträgt.

3. Prüfkopf (4) nach Anspruch 1 oder 2,
**dadurch gekennzeichnet,**
**dass** die Achse (26) oder Welle (42) mit einem Außendurchmesser von zumindest 10 mm an dem Bereich ausgebildet ist, an dem das Lager (27) an der Welle (42) oder Achse (26) angeordnet ist.

4. Prüfkopf (4) nach einem der Ansprüche 1 bis 3,
**dadurch gekennzeichnet,**
**dass** der Drehkörper mit einem maximalen Außendurchmesser von zumindest 50 mm ausgebildet ist.

5. Prüfkopf (4) nach einem der Ansprüche 1 bis 4,
**dadurch gekennzeichnet,**
**dass** der Schwenkarm (22) rohrförmig aus einem Faserverbundmaterial ausgebildet ist.

6. Prüfkopf (4) nach Anspruch 5,
**dadurch gekennzeichnet,**
**dass** der Schwenkarm (22) in Richtung zum freien Ende (40) verjüngt ausgebildet ist, und/oder in der Seitenansicht derart gekrümmt geformt ist, dass das freie Ende (40) des Schwenkarms (22) gegenüber dem an der Schwenkeinrichtung (19) befestigten Ende (40) ein Stück versetzt angeordnet ist.

7. Prüfkopf (4) nach einem der Ansprüche 1 bis 6,
**dadurch gekennzeichnet,**
**dass** der Motor (30) und der Drehkörper (28) auf der selben Ebene wie das zumindest eine Lager (27) angeordnet sind.

8. Prüfkopf (4) nach einem der Ansprüche 1 bis 7,
**dadurch gekennzeichnet,**
**dass** die Schwenkeinrichtung (19) die Welle (42) aufweist, welche eine maximale Länge von 40 mm und insbesondere eine maximale Länge von 30 mm aufweist.

9. Prüfkopf (4) nach einem der Ansprüche 1 bis 8,
**dadurch gekennzeichnet,**
**dass** die Hubeinrichtung (20) versetzt von der vertikalen Drehachse der Schwenkeinrichtung angeordnet ist, so dass ein Kabel, das zur Übertragung von Messsignalen dient, etwa entlang der vertikalen Drehachse (41) im Bereich zwischen dem Haltemodul (21) und dem Schlitten (14) geführt ist.

10. Prüfkopf (4) nach einem der Ansprüche 1 bis 9,
**dadurch gekennzeichnet,**
**dass** der Drehkörper (28) mehrere Permanentmagnete (29) am äußeren Umfang aufweist, welche mit Magnetfeldspulen eines Stators des Motors (30) zusammenwirken.

11. Prüfkopf (4) nach einem der Ansprüche 1 bis 10,
**dadurch gekennzeichnet,**
**dass** der Motor (30) einen Stator und einen Rotor umfasst, die sich jeweils um einen vollständigen Kreis erstrecken.

12. Prüfkopf (4) nach einem der Ansprüche 1 bis 11,
**dadurch gekennzeichnet,**
**dass** die Hubeinrichtung (20) an der Schwenkeinrichtung (19) angeordnet ist und einen Linearmotor zum Bewegen des Haltemoduls (21) aufweist, und/oder
**dass** der Schlitten (14) einen Läufer eines Linearmotors zum Bewegen des Schlittens aufweist, und/oder
**dass** der Prüfkopf (4) eine Kamera (44) zum Detektieren einer Prüfspitze einer Prüfsonde (23) aufweist.

13. Fingertester (1) zum Testen von Leiterplatten, insbesondere zum Testen von unbestückten Leiterplatten, umfassend
zumindest zwei Traversen (3), an welchen jeweils zumindest ein Prüfkopf (4) gemäß einem der Ansprüche 1 bis 12 verfahrbar angeordnet ist.

14. Fingertester (1) nach Anspruch 13,
**dadurch gekennzeichnet,**
**dass** eine jede Traverse (3) aus einem Steinblock ausgebildet ist.

15. Verfahren zum Testen von Leiterplatten, insbesondere zum Testen von unbestückten Leiterplatten, wobei ein Fingertester (1) nach Anspruch 13 oder 14 verwendet wird,
wobei nach einer Schwenkbewegung eines der Schwenkarme (22) grundsätzlich nicht mehr als 5 ms zum Einschwingen des jeweiligen Schwenkarmes gewartet, bis eine entsprechende Kontaktstelle einer zu testenden Leiterplatte kontaktiert wird.

## Claims

1. A test head (4) for a finger probe (1) for testing printed circuit boards, comprising
- a carriage (14) which can be movably arranged on a cross-member (3) of the finger probe,
- a holding module (21) for holding a swivel arm (22), which is designed to receive a test probe (23) at the free end (40) remote from the holding module (21),
- a lifting device (20), by means of which the holding module (21) is designed to be movable in the vertical direction with respect to the carriage, the lifting device (20) having a vertical guide rail with a roller bearing (37), and
- a swivel device (19) for rotating the holding module (21) and thus the swivel arm about a vertical axis of rotation (41), the swivel device (19) having a motor (30) for rotating the swivel device (19),
**characterized in that**
the swivel device (19) has a shaft (42) or axle (26), a rotary body (28) of the swivel device (19) being arranged concentrically to the shaft (42) or axle (26), so that the rotary body (28) surrounds the shaft (42) or axle (26), and the rotary body (28) is either mounted on the axle (26) with at least one bearing (27) or is mounted on the carriage (14) with at least one bearing (27) via the shaft (42), and
the motor (30) is designed as a direct drive, with the rotary body (28) forming the rotor of the motor (30).

2. The test head (4) according to claim 1,
**characterized in that**
the length of the swivel arm is at least 150 mm.

3. The test head (4) according to claim 1 or 2,
**characterized in that**
the axle (26) or shaft (42) is formed with an outside diameter of at least 10 mm in the area where the bearing (27) is arranged on the shaft (42) or axle (26).

4. The test head (4) according to any one of claims 1 to 3,
**characterized in that**
the rotary body is designed with a maximum outer diameter of at least 50 mm.

5. The test head (4) according to any one of claims 1 to 4,
**characterized in that**
the swivel arm (22) is made of a fiber composite material in tubular shape.

6. The test head (4) according to claim 5,
**characterized in that**
the swivel arm (22) is formed so as to be tapered toward the free end (40) and/or is curved in the side view in such a way that the free end (40) of the swivel arm (22) is arranged so as to be offset a little with respect to the end (40) fastened to the swivel device (19).

7. The test head (4) according to any one of claims 1 to 6,
**characterized in that**
the motor (30) and the rotary body (28) are arranged on the same plane as the at least one bearing (27).

8. The test head (4) according to any one of claims 1 to 7,
**characterized in that**
the swivel device (19) comprises the shaft (42), which has a maximum length of 40 mm and in particular a maximum length of 30 mm.

9. The test head (4) according to any one of claims 1 to 8,
**characterized in that**
the lifting device (20) is arranged so as to be offset from the vertical axis of rotation of the swivel device, so that a cable, which serves to transmit measurement signals, is guided approximately along the vertical axis of rotation (41) in the area between the holding module (21) and the carriage (14).

10. The test head (4) according to any one of claims 1 to 9,
**characterized in that**
the rotary body (28) has a plurality of permanent magnets (29) on the outer circumference, which interact with magnetic field coils of a stator of the motor (30).

11. The test head (4) according to any one of claims 1 to 10,
**characterized in that**
the motor (30) comprises a stator and a rotor, each extending around a complete circle.

12. The test head (4) according to any one of claims 1 to 11,
**characterized in that**
the lifting device (20) is arranged on the swivel device (19) and comprises a linear motor for moving the holding module (21), and/or
the carriage (14) has a slide of a linear motor for moving the carriage, and/or the test head (4) has a camera (44) for detecting a test tip of a test probe (23).

13. A finger probe (1) for testing printed circuit boards, in particular for testing bare printed circuit boards, comprising
at least two cross-members (3), on each of which at least one test head (4) according to any one of claims 1 to 12 is movably arranged.

14. The finger probe (1) according to claim 13,
**characterized in that**
each cross-member (3) is formed from a block of stone.

15. A method for testing printed circuit boards, in particular for testing bare printed circuit boards, wherein a finger probe (1) according to claim 13 or 14 is used,
wherein, after a swivel movement of one of the swivel arms (22), there is basically a waiting time of no more than 5 ms for the respective swivel arm to swing in until a corresponding contact point of a printed circuit board to be tested is contacted.

## Revendications

1. Tête de test (4) pour un testeur à doigt (1) destiné à tester des cartes de circuits imprimés, comprenant
- un chariot (14) pouvant être disposé de manière mobile sur une traverse (3) du testeur à doigt,
- un module de maintien (21) destiné à supporter un bras pivotant (22) conçu pour recevoir une sonde de test (23) à l'extrémité libre (40) éloignée du module de maintien (21),
- un dispositif de levage (20), au moyen duquel le module de maintien (21) est conçu pour être mobile dans la direction verticale par rapport au chariot, le dispositif de levage (20) ayant un rail de guidage vertical avec un roulement à rouleaux (37), et
- un dispositif de pivotement (19) pour faire tourner le module de maintien (21) et donc le bras pivotant autour d'un axe de rotation vertical (41), le dispositif de pivotement (19) comportant un moteur (30) pour faire tourner le dispositif de pivotement (19),
**caractérisé en ce que**
le dispositif de pivotement (19) comprend un arbre (42) ou un axe (26), un corps rotatif (28) du dispositif de pivotement (19) étant disposé concentriquement à l'arbre (42) ou à l'axe (26), de sorte que le corps rotatif (28) entoure l'arbre (42) ou l'axe (26), et le corps rotatif (28) est soit monté sur l'axe (26) avec au moins un palier (27), soit monté sur le chariot (14) avec au moins un palier (27) par l'intermédiaire de l'arbre (42), et
le moteur (30) est conçu comme un entraînement direct, le corps rotatif (28) formant le rotor du moteur (30).

2. La tête de test (4) selon la revendication 1,
**caractérisée en ce que**
la longueur du bras pivotant est d'au moins 150 mm.

3. La tête de test (4) selon la revendication 1 ou 2,
**caractérisée en ce que**
l'axe (26) ou l'arbre (42) est formé avec un diamètre extérieur d'au moins 10 mm dans la zone où le palier (27) est disposé sur l'arbre (42) ou l'axe (26).

4. La tête de test (4) selon l'une quelconque des revendications 1 à 3,
**caractérisée en ce que**
le corps rotatif est réalisé avec un diamètre extérieur maximal d'au moins 50 mm.

5. La tête de test (4) selon l'une quelconque des revendications 1 à 4,
**caractérisée en ce que**
le bras pivotant (22) est constitué d'un matériau composite à base de fibres et comprend une forme tubulaire.

6. La tête de test (4) selon la revendication 5,
**caractérisée en ce que**
le bras pivotant (22) est effilé vers l'extrémité libre (40) et/ou est incurvé dans la vue latérale de telle sorte que l'extrémité libre (40) du bras pivotant (22) soit disposée de manière à être légèrement décalée par rapport à l'extrémité (40) fixée au dispositif de pivotement (19).

7. La tête de test (4) selon l'une quelconque des revendications 1 à 6,
**caractérisée en ce que**
le moteur (30) et le corps rotatif (28) sont disposés sur le même plan que ledit au moins un palier (27).

8. La tête de test (4) selon l'une quelconque des revendications 1 à 7,
**caractérisée en ce que**
le dispositif de pivotement (19) comprend l'arbre (42), qui a une longueur maximale de 40 mm, et en particulier une longueur maximale de 30 mm.

9. La tête de test (4) selon l'une quelconque des revendications 1 à 8,
**caractérisée en ce que**
le dispositif de levage (20) est disposé de manière décalée par rapport à l'axe de rotation vertical du dispositif de pivotement, de sorte qu'un câble servant à transmettre des signaux de mesure soit guidé approximativement le long de l'axe de rotation vertical (41) dans la zone entre le module de maintien (21) et le chariot (14).

10. La tête de test (4) selon l'une quelconque des revendications 1 à 9,
**caractérisée en ce que**
le corps rotatif (28) comprend une pluralité d'aimants permanents (29) sur la circonférence extérieure, qui interagissent avec des bobines de champ magnétique d'un stator du moteur (30).

11. La tête de test (4) selon l'une quelconque des revendications 1 à 10,
**caractérisée en ce que**
le moteur (30) comprend un stator et un rotor, chacun s'étendant sur un cercle complet.

12. La tête de test (4) selon l'une quelconque des revendications 1 à 11,
**caractérisée en ce que**
le dispositif de levage (20) est disposé sur le dispositif de pivotement (19) et comprend un moteur linéaire pour déplacer le module de maintien (21), et/ou
le chariot (14) comprend un induit d'un moteur linéaire pour déplacer le chariot, et/ou la tête de test (4) comprend une caméra (44) pour détecter une pointe de test d'une sonde de test (23).

13. Testeur à doigt (1) destiné à tester des cartes de circuits imprimés, en particulier pour tester des cartes de circuits imprimés nues, comprenant
deux traverses (3), sur chacune desquelles est disposée de manière mobile au moins une tête de test (4) selon l'une quelconque des revendications 1 à 12.

14. Le testeur à doigt (1) selon la revendication 13,
**caractérisé en ce que**
chaque traverse (3) est formée à partir d'un bloc de pierre.

15. Procédé destiné à tester des cartes de circuits imprimés, en particulier pour tester des cartes de circuits imprimés nues, un testeur à doigt (1) selon la revendication 13 ou 14 étant utilisé,
sachant que, après un mouvement de pivotement de l'un des bras pivotants (22), il y a en principe un temps d'attente de 5 ms maximum pour que le bras pivotant respectif s'établisse jusqu'à ce qu'un point de contact correspondant d'une carte de circuits imprimés à tester soit contacté.
